# EUROPÄISCHE PATENTSCHRIFT

(11) **EP 0 622 874 B1**
(45) Veröffentlichungstag und Bekanntmachung des Hinweises auf die Patenterteilung: **12.06.1996**
(21) Anmeldenummer: 94104343.2
(22) Anmeldetag: 19.03.1994
(51) Int. Cl.: H01S 3/025, G02B 6/42

(54) **Anordnung zur Ankopplung eines optoelektronischen Empfangselementes an ein optoelektronisches Sendeelement**
Arrangement for coupling an opto-electronic receiving element to an opto-electronic transmitting element
Arrangement de couplage entre un élément optoélectronique récepteur et un élément optoélectronique émetteur

(30) Priorität: 24.04.1993 DE 4313492
(43) Veröffentlichungstag der Anmeldung: 02.11.1994
(73) Patentinhaber: ROBERT BOSCH GMBH, 70442 Stuttgart (DE)
(72) Erfinder: Schwaderer, Bernhard, D-71554 Weisach i.T. (DE); Kuke, Albrecht, Dr., D-71549 Auenwald (DE)

(56) Entgegenhaltungen:
- EP-A- 0 084 003
- EP-A- 0 473 339
- WO-A-88/10018
- PATENT ABSTRACTS OF JAPAN vol. 10, no. 217 (E-423) 29. Juli 1986 & JP-A-61 054 689 (FUJITSU LTD) 18. März 1986

## Beschreibung

Die Erfindung betrifft eine Anordnung zur Ankopplung eines optoelektronischen Empfangselementes an ein optoelektronisches Sendeelement, insbesondere einer Monitordiode an einen kantenemittierenden Laser, wobei das Empfangselement auf der Oberseite eines einteiligen Siliziumträgers montiert ist und dessen lichtempfindliche Fläche der Oberseite des Trägers zugewandt ist und sich mindestens ein optisches Umlenkbauelement am Träger befindet.

Aus der DE 35 43 558 A1 ist eine optoelektrische Koppelanordnung zwischen Lichtwellenleiter und Fotodetektor bekannt. In einem Ausführungsbeispiel wird angegeben, daß der Lichtwellenleiter sich auf der einen Seite und das Empfangselement sich auf der anderen Seite des Silizium (Si)-Trägers befindet. Der Lichtwellenleiter ist dabei in einer V-Nut befestigt, in der sich auch ein Spiegel befindet. Die Herstellung einer solchen optoelektrischen Koppelanordnung ist sehr aufwendig, da eine Nut und ein Durchbruch vorgesehen sind. Zudem ist eine Justage des Spiegels notwendig.

Bei dem aus der DE 35 43 558 A1 bekannten Vorschlag liegt die lichtaussendende Faser in einer Vertiefung unterhalb der Empfangsdiode. Durch die tiefere Lage der Faser wird erreicht, daß nahezu alles Licht, das aus der Faser austritt in die Empfangsdiode fällt, was bei einer Empfangsdioden-Ankopplung auch erforderlich ist, da hier ein hoher Koppelwirkungsgrad benötigt wird.

Die Erfindung betrifft insbesondere die Ankopplung einer Monitorfotodiode an einen Halbleiterlaser. Gebräuchliche Halbleiterlaser (Ausnahme: SELD-Laser) emittieren das Licht an zwei gegenüberliegenden Kanten. Das an der vorderen Kante austretende Licht wird als Nutzsignal verwendet und über eine Optik entweder kollimiert oder in eine Faser gekoppelt. Zur Regellung der temperatur- und alterungsabhängigen Lichtleistung ist es erforderlich, den Treiberstrom des Halbleiterlasers der erforderlichen Lichtleistung entsprechend einzustellen. Hierzu dient eine Regeldiode, die am rückwärtigen Ausgang des Laser angebracht wird. Im Gegensatz zum Laser befindet sich die aktive Fläche der Fotodiode üblicherweise nicht an einer Kante sondern auf der Chipoberfläche bzw -unterfläche. Um die lichtempfindliche Fläche der Fotodiode in den Strahlengang des Lasers zu bringen, wird nach dem Stand der Technik die Fotodiode auf einem Zwischenträger montiert, der mit seiner Kante auf der Montageebene des Lasers befestigt wird. Die Fotodiode wird dabei in einem ersten Montageschritt auf dem Zwischenträger montiert und kontaktiert. In einem zweiten Montageschritt wird der Zwischenträger mit der Fotodiode so auf der Montageebene des Lasers montiert, daß die Fotodiode senkrecht oder nahezu senkrecht zur Strahlrichtung des Lasers steht. Besonders aufwendig ist hierbei die Kontaktierung der Fotodiode die zunächst zu Leiterbahnen auf dem Zwischenträger gebondet wird. Der Zwischenträger benötigt Kantenumkontaktierungen, damit der elektrische Kontakt zur Montageebene des Lasers hergestellt werden kann. Es ist nicht möglich, den Laser-Chip und den Fotodioden-Chip in einem Arbeitsgang durch Bonddrähte zu kontaktieren, da bei einem Bonder die zu verbindenden Leiterflächen in einer Ebene oder in zwei zueinander parallelen oder nahezu parallelen Ebenen liegen müssen.

In EP-A-0 473 339 ist ein kantenemittierender laser beschrieben, der auf der Oberfläche eines Trägers montiert ist, welcher eine Vertiefung aufweist. Därüber wird eine Deckplatte gelegt, an deren Unterseite eine Photodiode und eine Kugellinse angebracht sind. Vom Laser ausgesandtes Licht wird durch die Vugellinse und über eine Verspiegelung in der Vertiefung auf die lichtempfindliche Fläche der Photodiode gelenkt.

Es ist Aufgabe der Erfindung, eine Anordnung zur Ankopplung eines optoelektronischen Empfangselementes an ein Sendeelement, insbesondere einer Monitordiode an einen kantenemittierenden Laser anzugeben, die besonders einfach aufgebaut ist und obige Nachteile bei der Montage überwindet.

Die Aufgabe wird von einer Anordnung mit den Merkmalen des Patentanspruches 1 gelöst. Vorteilhafte Weiterbildungen sind in den Unteransprüchen angegeben.

Bei der angegebenen Lösung wird auf einen Teil des Koppelwirkungsgrades verzichtet, was bei der Ankopplung einer Monitordiode vertretbar ist. Dadurch erhält man den Vorteil, daß der Laser nicht tiefer gesetzt werden muß als die Monitordiode. Wollte man zur Erzielung eines höheren Koppelwirkungsgrades, der hier gar nicht benötigt wird, den Laser tiefer setzen, so wäre eine ebene Montagefläche für den Laser unterhalb der Trägeroberfläche erforderlich. Eine solche Montagefläche ließe sich im Falle, daß der Träger durch anisotropes Ätzen von Silizium hergestellt wird, nur durch einen aufwendigeren zweistufigen Ätzprozeß herstellen. Auch durch Prägen läßt sich eine tieferliegende ebene Montagefläche im Gegensatz zu spitz zulaufenden Vertiefungen nur schwer herstellen. Eine Kontaktierung des Lasers über die Leiterbahn ist bei verschiedenen Höhen zwischen der Montagefläche des Lasers und der Trägeroberfläche ebenfalls nur mit größerem Aufwand möglich.

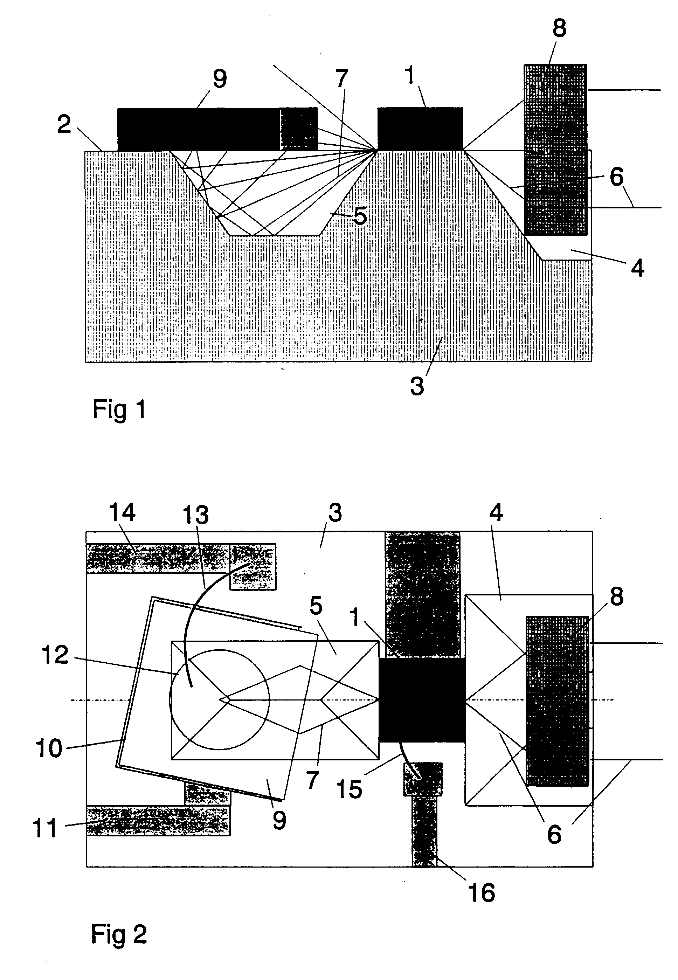

Die erfindungsgemäße Lösung wird anhand der Figur 1 (Querschnitt) und der Figur 2 (Draufsicht) erläutert. Der Halbleiterlaser 1 ist auf der Oberfläche 2 eines Trägers 3 montiert. Dieser Träger enthält eine erste Vertiefung 4 und eine zweite Vertiefung 5 jeweils an der Vorder- bzw. Rückseite des Halbleiterlasers. Die Vertiefungen 4 und 5 dienen der freien Strahlausbreitung der aus dem Laser an seiner Vorder- und Rückseite austretenden Lichtbündel 6 und 7. Die Lage der Vertiefungen 4 und 5 ist so gewählt, daß sie mindestens bis an die Vorder- bzw. Rückseite des Lasers reichen, so daß die Lichtbündel nicht durch die Trägeroberfläche abgedeckt werden. Die Vertiefung auf der Vorderseite des Lasers kann gleichzeitig zur Aufnahme einer Abbildungsoptik 8 dienen, die den Strahl entweder kollimiert oder auf eine hier nicht gezeigte Lichtleitfaser fokussiert. Die rückwärtige Vertiefung 5 besitzt erfindungsgemäß mindestens an ihrer dem Laser abgewandten Seite und an ihren Seitenflächen geneigte Wände, die verspiegelt sind. Der Träger 3 kann vorzugsweise aus einkristallinem Silizium mit der kristallografischen (100)-Ebene in seiner Oberfläche 2 bestehen. Dann lassen sich die besagten Vertiefungen 4 und 5 durch anisotropes Ätzen herstellen wobei die erforderliche Neigung der Wände sich mit hoher Präzision unter einem Böschungswinkel von 54,7 ° von selbst einstellt. Auch andere Materialien zur Herstellung des Trägers und der Vertiefungen sind möglich. Beispielsweise kann der Träger aus Metall und die Vertiefungen durch einen Prägeprozeß erzeugt werden. Die zur Regelung der Laserleistung erforderliche Monitordiode 9 wird so über der Vertiefung 5 montiert, daß ihre lichtempfindliche Fläche der Vertiefung 5 zugewandt ist. Die Vertiefung 5 ist dabei so schmal, daß die Fotodiode mit ihrem Rand auf den Seitenrändern und auf dem dem Laser abgewandten Rand der Vertiefung 5 aufliegen kann. Zur Montage und Kontaktierung einer Elektrode der Fotodiode dient eine um den hinteren Teil der Vertiefung 5 liegende Leiterschicht 10 mit einer Anschlußleitung 11. Die Kontaktierfläche 10 umfaßt etwa die Fläche der Monitordiode. Zweckmäßigerweise ist diese Fläche so strukturiert, daß nach der Montage der Fotodiode die dem Laser zugewandte Kantenfläche der Fotodiode einen schrägen Winkel mit der Strahlrichtung des aus dem Laser austretenden Strahlbündels bildet, um schädliche Rückreflexionen von der Diodenkante in den Laser zu vermeiden. Die lichtempfindliche Fläche 12 der Monitordiode soll dabei möglichst ganz über der Vertiefung 5 zu liegen kommen. Die andere Elektrode der Fotodiode kann über einen Bonddraht 13 mit einer Anschlußleitung 14 oder in Flip-Chip-Technik ebenfalls mit einer weiteren separaten Leiterbahn auf der Trägeroberfläche (hier nicht gezeichnet) verbunden werden . Die Montage und Kontaktierung der Monitordiode kann bei der erfindungsgemäßen Lösung in einem Arbeitsgang mit der Montage und Kontaktierung des Halbleiterlasers 1 erfolgen, der mit einer Elektrode auf der Leiterbahn 14 montiert ist und mit der anderen Elektrode über den Bonddraht 15 mit der Leiterbahn 16 verbunden ist.

Ein gewisser Nachteil der erfindungsgemäßen Lösung liegt darin, daß nur höchstens die Hälfte des aus der Laserdiode austretenden Lichtbündels die Fotodiode erreichen kann. Für den gewählten Anwendungsfall der Fotodiode als Monitordiode spielt dies jedoch keine Rolle, da im Gegensatz zur Anwendung einer Fotodiode als Empfangsdiode bei der Anwendung als Monitordiode stets genügend Lichtleistung vorhanden ist. Die Lichtleistung würde für die Monitordiode auch dann noch ausreichen, wenn der Laser nicht wie in Figur 1 gezeichnet an seiner unteren Kante sondern an seiner oberen Kante abstrahlen würde. Dann würde zwar etwas weniger Licht in die Vertiefung 5 fallen, der Koppelwirkungsgrad von unter 50 % würde aber dennoch reichen.

Die Vertiefung 5 kann entweder so ausgebildet sein, daß ihre Grundfläche eine ebene Fläche ist. Im Fall, daß die Vertiefung durch anisotropes Ätzen von Silizium hergestellt wird, würde man die Ätzung nach einer vorgewählten Zeit stoppen. Dann bildet sich am Boden der Vertiefung eine Ebene (100)-Fläche. Die Ätzung kann auch so weit geführt werden, bis die beiden Seitenflächen in einem spitzen Winkel von 70,5° zusammentreffen. Auch bei weiterer Ätzung, beispielsweise um die Vertiefung 4 tiefer zu ätzen als die Vertiefung 5, würde sich die Vertiefung 5 dann nahezu nicht mehr verändern.

## Patentansprüche

1. Anordnung zur Ankopplung eines optoelektronischen Empfangselementes an ein optoelektronisches Sendeelement, insbesondere einer Monitordiode an einen kantenemittierenden Laser, wobei das Empfangselement (9) auf der Oberseite (2) eines Trägers (3) montiert ist und die lichtempfindliche Fläche des Empfangselementes (9) der Oberseite (2) zugewandt ist und sich mindestens ein optisches Umlenkbauelement am Träger (3) befindet, wobei
das Sendeelement (1) auf der Oberseite (2) des Trägers (3) montiert ist,
der Träger (3) auf der Oberseite (2) eine erste Vertiefung (5) aufweist,
das Sendeelement (1) derart angebracht ist, daß das von einer ersten Kante emittierte Lichtbündel (7) zumindest teilweise in die Vertiefung (5) gelangt,
das Empfangselement (9) sich über die Vertiefung (5) erstreckt,
die Wände der Vertiefung (5) bereichsweise verspiegelt sind und das vom Sendeelement (1) emittierte Lichtbündel (7) teilweise an den Wänden der Vertiefung (5) gespiegelt wird und auf die lichtempfindliche Fläche des Empfangselementes (9) fällt.

2. Anordnung nach Anspruch 1, dadurch gekennzeichnet, daß der Träger (3) auf der Oberseite (2) eine weitere Vertiefung (4) aufweist, daß das Sendeelement (1) derart angebracht ist, daß das von der zweiten Kante emittierte Lichtbündel (6) teilweise in die weitere Vertiefung (4) gelangt
und daß in der weiteren Vertiefung (4) weitere optische Elemente angebracht sind.

3. Anordnung nach Anspruch 2, dadurch gekennzeichnet, daß in der weiteren Vertiefung (4) eine Abbildungsoptik (8) vorgesehen ist.

4. Anordnung nach einem der Ansprüche 1 bis 3, dadurch gekennzeichnet, daß der Träger (3) aus einkristallinem Silizium besteht und die Vertiefungen (4, 5) durch anisotropes Ätzen hergestellt sind.

5. Anordnung nach einem der Ansprüche 1 bis 3, dadurch gekennzeichnet, daß die Vertiefungen (4, 5) durch Prägen in geeigneten Materialien hergestellt sind.

## Claims

1. Arrangement for coupling an optoelectronic reception element to an optoelectronic transmission element, in particular a monitor diode to an edge-emitting laser, the reception element (9) being mounted on the upper side (2) of a support (3) and the light-sensitive surface of the reception element (9) facing the upper side (2) and at least one optical deflection component being situated on the support (3), the transmission element (1) being mounted on the upper side (2) of the support (3), the support (3) having a first indentation (5) on the upper side (2), the transmission element (1) being fitted in such a way that the light bundle (7) emitted by a first edge propagates at least partly into the indentation (5), the reception element (9) extending over the indentation (5), the walls of the indentation (5) being zonally mirrored and the light bundle (7) emitted by the transmission element (1) being partially reflected from the walls of the indentation (5) and incident on the light-sensitive face of the reception element (9).

2. Arrangement according to Claim 1, characterized in that the support (3) has a further indentation (4) on the upper side (2), in that the transmission element (1) is fitted in such a way that the light bundle (6) emitted by the second edge propagates partly into the further indentation (4) and in that further optical elements are fitted in the further indentation (4).

3. Arrangement according to Claim 2, characterized in that imaging optics (8) are provided in the further indentation (4).

4. Arrangement according to one of Claims 1 to 3, characterized in that the support (3) consists of monocrystalline silicon and the indentations (4, 5) are produced by anisotropic etching.

5. Arrangement according to one of Claims 1 to 3, characterized in that the indentations (4, 5) are produced by embossing in suitable materials.

## Revendications

1. Dispositif de couplage entre un élément optoélectronique récepteur et un élément optoélectronique émetteur, notamment une diode de contrôle pour un laser à émission latérale, l'élément récepteur (9) étant monté sur la face supérieure (2) d'un support (3) la surface photosensible de l'élément récepteur (9) étant tournée vers la face supérieure (2), au moins un composant de renvoi optique étant prévu sur le support (3), l'élément émetteur (1) étant monté sur la face supérieure (2) du support (3),muni d'une première cavité (5) dans sa face supérieure (2), l'élément émetteur (1) étant monté de façon que le faisceau lumineux (7) émis par son premier bord arrive au moins partiellement dans la cavité (5), l'élément récepteur (9) s'étendant par-dessus la cavité (5), dont les parois (5) ont des zones en forme de miroirs, et le faisceau lumineux (7) émis par l'élément émetteur (1) étant réfléchi partiellement par les parois de la cavité (5) pour arriver sur la surface photosensible de l'élément récepteur (9).

2. Dispositif selon la revendication 1, caractérisé en ce que le support (3) comporte, sur la face supérieure (2), une autre cavité (4), en ce que l'élément émetteur (1) est monté pour que le faisceau lumineux (6) émis par le second bord arrive partiellement dans l'autre cavité (4) et en ce que cette autre cavité (4), comporte d'autres éléments optiques.

3. Dispositif selon la revendication 2, caractérisé par une optique image (8) prévue dans l'autre cavité (4).

4. Dispositif selon l'une des revendications 1 à 3, caractérisé en ce que le support (3) est en un silicium monocristallin, et les cavités (4, 5) sont réalisées par attaque chimique anisotrope.

5. Dispositif selon l'une des revendications 1 à 3, caractérisé en ce que les cavités (4, 5) sont réalisées par matriçage dans des matériaux appropriés.
